# FASCICULE DE BREVET EUROPEEN

(11) **EP 0 786 100 B1**
(45) Date de publication et mention de la délivrance du brevet: **28.07.1999**
(21) Numéro de dépôt: 95931251.3
(22) Date de dépôt: 15.09.1995
(51) Int. Cl.: G02B 6/12, H01S 3/103, G02F 1/01, G02F 1/025

(54) **FILTRE OPTIQUE POUR PLUSIEURS LONGUEURS D'ONDES GUIDEES**
OPTISCHER MULTIWELLENLAENGEN-WELLENLEITERFILTER
OPTICAL FILTER FOR A PLURALITY OF GUIDED WAVELENGTHS

(30) Priorité: 10.10.1994 FR 9412060
(43) Date de publication de la demande: 30.07.1997
(73) Titulaire: FRANCE TELECOM, 75015 Paris (FR)
(72) Inventeur: TALNEAU, Anne, F-75013 Paris (FR)
(74) Mandataire: Texier, Christian
(86) Numéro de dépôt international: FR9501187
(87) Numéro de publication internationale: WO9611416

(56) Documents cités:
- GB-A- 2 269 679
- GB-A- 2 270 174
- US-A- 4 885 753
- PATENT ABSTRACTS OF JAPAN vol. 011 no. 041 (E-478) ,6 Février 1987 & JP,A,61 206285 (MITSUBISHI ELECTRIC CORP) 12 Septembre 1986,
- PATENT ABSTRACTS OF JAPAN vol. 010 no. 093 (P-445) ,10 Avril 1986 & JP,A,60 229001 (KOGYO GIJUTSUIN;OTHERS: 0J) 14 Novembre 1985,
- PATENT ABSTRACTS OF JAPAN vol. 011 no. 099 (E-493) ,27 Mars 1987 & JP,A,61 251183 (FUJITSU LTD) 8 Novembre 1986,
- IEEE JOURNAL OF QUANTUM ELECTRONICS, vol. 29, no. 6, Juin 1993 NEW YORK US, pages 1824-1834, XP 000397620 V. JAYARAMAN ET AL 'Theory, design, and performance of extended tuning range semiconductor lasers with sampled gratings' cité dans la demande
- IEEE JOURNAL OF QUANTUM ELECTRONICS, vol. 29, no. 6, Juin 1993 NEW YORK US, pages 1817-1823, XP 000297619 Y. TOHMORI ET AL 'Broad range wavelength tunable superstructure grating (SSG) DBR lasers' cité dans la demande

## Description

La présente invention concerne le domaine des filtres optiques.

La présente invention peut trouver application dans la réalisation d'un filtre optique passif ou actif.

Plus précisément, la présente invention a pour but de proposer un filtre optique pour un grand nombre (supérieur à deux) de longueurs d'ondes guidées.

Le filtre multi-longueurs d'ondes conforme à la présente invention peut être inclus par exemple dans une source laser multi-longueurs d'ondes.

Ces sources sont des composants fondamentaux pour les futurs systèmes de communication à multiplexage. En l'état actuel de la technique, l'inventeur a déterminé notamment qu'il existe un intérêt particulier dans le développement d'une source qui couvre la bande de l'erbium (1530 à 1560 nm) avec un très grand nombre de canaux accessibles, par exemple au moins 50 canaux.

Le filtre conforme à la présente invention peut aussi servir à sélectionner, dans une source à spectre étendue, les fréquences pour lesquelles il est réalisé.

Le filtre conforme à la présente invention peut être inclus dans une succession d'éléments optiques guidant, ou encore être défini in situ sur une fibre.

Deux types d'objets mettant en oeuvre un peigne de fréquences ont été récemment proposés pour les sources laser multi-longueurs d'ondes.

Dans ces structures de type à réflecteur de Bragg distribué (Distributed Bragg Reflector-DBR) les éléments filtrants (peigne de fréquences) se trouvent de part et d'autre d'une zone active dans la direction de propagation de la lumière.

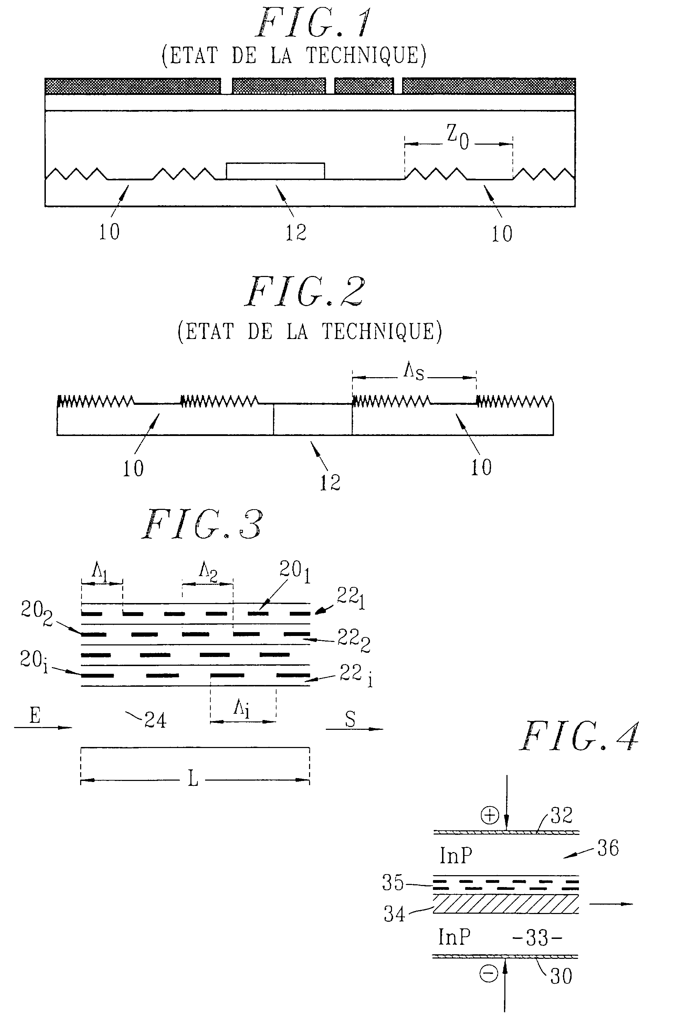

Ces deux structures antérieures connues sont schématisées sur les figures 1 et 2 annexées.

La première structure connue, schématisée sur la figure 1 annexée, est décrite dans le document Jayaraman et al. "Theory, Design, and Performance of Extended Tuning Range Semiconductor Lasers with Sampled Gratings" IEEE, Journal of Quantum Electronics, vol. 29, n° 6, Juin 1993 et dans le document Jayaraman et al. "Continuous-Wave Operation of Sampled Grating Tunable Lasers with 10 mwatt Output Power, >60 nm Tuning, and Monotonic Tuning Characteristics" 6ème Int. Conf. Indium Phosphide and Related Materials, Mars, 94, Santa Barbara. Cette source laser comprend un réseau échantilonné 10 de part et d'autre d'une zone active 12. Plus précisément, le guide comporte périodiquement (avec une période Z₀) des zones avec réseau de diffraction. Chaque zone avec réseau se comporte comme un réflecteur réparti. La période de l'échantillonnage est définie par la périodicité Z₀ des zones avec réseau.

La seconde structure antérieure connue illustrée sur la figure 2, est décrite par exemple dans le document Tohmori et al. "Broad-Range Wavelength-Tunable Superstructure Grating (SSG) DBR Lasers" IEEE, Journal of Quantum Electronics, vol. 29, n° 6, Juin 1993. Cette structure comprend un réseau à superstructure (Super Structure Grating-SSG). Là encore, on retrouve des guides à réseau 10 de part et d'autre d'une zone active 12. Cependant, dans cette seconde source, chaque guide 10 comporte du réseau sur toute sa longueur. C'est la période (ou la phase) du réseau qui varie et ce périodiquement, avec une période Λs. La période du peigne de fréquences obtenue est définie par la périodicité Λs sur la période du réseau.

La première structure connue illustrée sur la figure 1 modifie périodiquement en tout ou rien l'amplitude du couplage assuré par le réseau. La seconde structure connue illustrée sur la figure 2 annexée modifie la phase du signal.

De nombreux autres documents ont analysé l'influence de différentes structures de réseaux sur un signal optique.

Le document Heismann et al. "Polarization-Independent Wavelength Filter Using a Grating-Assisted Vertical Directional Coupler in InP" Post deadline paper, ECOC 93, décrit par exemple un filtre associé à un coupleur directionnel. Le coupleur directionnel est un réseau comportant deux périodes et permet de filtrer séparément les deux polarisations TE et TM.

Le document "High speed and high density wavelength multichannel butt-jointed DBR lasers" Electronics Letters, 10 Octobre 1991, vol. 27, n° 21, pp 1969-1971, décrit un filtre réalisé par gravure locale d'un réseau et contrôlé par le courant.

Le document Peng "Rigorous analysis of guided waves in doubly periodic structures", Optical Society of America, vol.7, n° 8, Août 1990, analyse mathématiquement les effets d'interaction de deux réseaux sur la propagation d'une onde, dans une direction, dans un film pris en sandwich entre ces deux réseaux et conclut que l'un des réseaux doit avoir une période double de la période du second réseau pour autoriser une propagation.

Les documents Minier et al. "Superimposed Phase Gratings in Planar Optical Waveguides for Wavelength Demultiplexing Applications", IEEE Photonics Technology Letters, vol. 5, n° 3, Mars 1993 et Wang et al. "Wavelength-division multiplexing and demultiplexing on locally sensitized single-mode polymer microstructure waveguides", Optics Letters, vol. 15, n° 7, 1er Avril 1990, étudient les effets de diffraction obtenus avec des réseaux holographiques de volume dans un guide optique planaire.

Le document GB-A-2270174 concerne un filtre optique accordable composé de deux réseaux de périodes différentes. Les réseaux sont placés successivement le long d'un guide. Chaque réseau agit seul sur toutes les longueurs d'onde.

Le document GB-A-2 269 679 décrit une structure similaire à 4 réseaux répartis successivement le long d'un guide.

Le document US-A-4885753 concerne des lasers largement accordables. Selon la majorité des modes de réalisation évoqués dans ce document, les réseaux sont réalisés successivement le long du guide et chaque réseau de période donnée est commandé par une électrode. Dans une variante, il est proposé de placer un premier réseau en dessous des couches guides et un second réseau au dessus de celles-ci. Le concept ainsi proposé limite le nombre de longueurs d'onde à 2.

Les structures de source laser multi-longueurs d'ondes connues à réseaux échantillonnés ou à réseaux en superstructure présentent différents inconvénients.

En effet, les structures à réflecteur de Bragg distribué comportant un des deux filtres multifréquence décrits dans ces deux documents sont limitées en terme de canaux accessibles. Il semble en effet difficile, avec les méthodes de réalisation décrites, et en conservant un objet de longueur raisonnable (inférieure à 2mm) de diminuer l'espacement entre canaux, car les dimensions géométriques du filtre fixent l'espacement.

En particulier, dans la structure à réseaux échantillonnés présentée par Jayaraman, l'espacement en longueur d'onde entre deux canaux est fixé par la période Z₀ de l'échantillonnage. Cet espacement entre deux canaux varie en 1/Z₀. Avec Z₀ de l'ordre de 50µm, on a un espacement dλ, espacement en longueur d'onde entre deux canaux du peigne, de 6nm.

Pour obtenir un espacement dλ de l'ordre de 1nm, il faudrait une période d'échantillonnage Z₀ de 300µm. Or, pour être sélectif entre deux canaux, le filtre doit comporter au moins cinq à six périodes Z₀. Cela conduit à un filtre d'une longueur de 6x300µm, soit 1,8mm. Sachant qu'une source laser accordable comporte deux filtres et une zone à gain, l'objet conduisant à un espacement entre deux canaux de l'ordre de 1nm, avec cette méthode de réalisation, mesurerait au moins 4mm. Une telle longueur ne peut étre envisagée pour une source laser car elle conduirait à des pertes trop élevées au cours de la propagation.

La présente invention a maintenant pour but de perfectionner les filtres multi-longueurs d'ondes guidées connus.

Plus précisément, la présente invention a pour but de proposer un filtre optique multi-longueurs d'ondes guidées pour lequel l'espacement entre les longueurs d'ondes peut varier de plusieurs nm (typiquement de 10 à 20nm) jusqu'à 0,5nm, pour lequel la réflectivité de chaque fréquence peut être contrôlée (toutes égales ou non) et pour lequel l'espacement entre les longueurs d'ondes ne dépend pas de la géométrie (longueur) du filtre.

Dans le cadre de l'invention, le filtre peut mesurer typiquement de 100µm à 500µm.

Le nombre total de longueurs d'ondes obtenu dépendra de la maitrise technologique. Ce nombre est typiquement supérieur à 2.

Ces différents buts sont atteints dans le cadre de la présente invention grâce à un filtre du type défini en revendication 1 annexée laquelle est délimitée sous forme d'un préambule et d'une partie caractérisante par rapport au document GB-A-2 269 679.

D'autres caractéristiques, buts et avantages de la présente invention apparaîtront à la lecture de la description détaillée qui va suivre, et en regard des dessins annexés donnés à titre d'exemples non limitatifs et sur lesquels :
- les figures 1 et 2 précédemment décrites représentent schématiquement des structures de sources laser multi-longueurs d'ondes conformes à l'état de la technique,
- la figure 3 représente une vue en coupe d'un filtre passif schématisant la présente invention,
- la figure 4 représente une vue en coupe d'un filtre actif schématisant la présente invention,
- la figure 5 schématise la forme géométrique d'un filtre conforme à la présente invention, et
- les figures 6 et 7 représentent le spectre à bas courant relevé sur deux structures actives conformes à la présente invention.

Comme on l'a évoqué précédemment, au lieu d'être obtenues par échantillonnage d'un réseau (Transformée de Fourier d'une structure périodique), et donc dépendre des longueurs caractéristiques de ce réseau, comme cela est enseigné dans l'état de la technique, selon l'invention les différentes fréquences dont on veut disposer en sortie du filtre sont toutes présentes en chaque partie élémentaire de ce filtre.

Plus précisément, pour cela, le filtre optique multi-longueurs d'ondes guidées conforme à la présente invention comprend un réseau continu comportant en chaque partie élémentaire les différents réseaux dont les périodes correspondent respectivement aux différentes longueurs d'onde du filtre. Plus précisément, les différents réseaux élémentaires précités peuvent être prévus dans une même couche guidante ou encore dans différentes couches guidantes superposées.

Les phases relatives de ces différents réseaux peuvent être aléatoires ou contrôlées.

On a par exemple illustré sur la figure 3 annexée, une structure de filtre passif conforme à la présente invention comportant i réseaux élémentaires 20₁ à 20ᵢ inscrits respectivement dans des couches guidantes 22₁ à 22ᵢ spécifiques superposées à un guide passif 24.

Sur la figure 3 annexée, on a schématisé sous la référence E l'entrée de la lumière dans le guide passif 24, sous la référence S la sortie de la lumière hors de ce guide passif 24 et sous la référence L la longueur d'une section élémentaire du filtre passif conforme à la présente invention.

La période de chaque réseau 20ᵢ est référencée Λi sur la figure 3.

Chaque période Λi d'un réseaux 20ᵢ inscrit dans une couche 22ᵢ spécifique correspond à un multiple entier m de la demi-longueur d'onde guidée, soit Λi = m. λ_{gi}/2.

Bien entendu, en variante, un filtre actif équivalent pourrait être obtenu en inscrivant les réseaux 20ᵢ de période Λi dans une seule et même couche superposée au guide passif 24.

Les réseaux 20ᵢ constituent ainsi un réseau global continu de surface, et réflectif, pour les ondes guidées dans la couche 24.

L'inventeur a déterminé par calcul et vérifié expérimentalement que les effets des différents réseaux 20ᵢ sont découplés dès que l'espacement dλ entre deux canaux est supérieur ou égal à 0,5nm.

En outre, il s'avère que pour assurer sa fonction de filtre, c'est-à-dire assurer le couplage nécessaire pour chaque fréquence, chaque section guidante à réseaux 20ᵢ doit posséder de préférence une longueur L variant au minimum de 100µm à 500µm selon la valeur voulue pour le maximum de la réflectivité.

Toutes les fréquences existant simultanément en chaque partie élémentaire du filtre, selon l'invention, cette zone guidante comportant le réseau assure un couplage pour toutes les fréquences. La réflectivité à une longueur d'onde donnée est contrôlée par l'efficacité du réseau à cette fréquence.

Le filtre multi-longueurs d'ondes conforme à la présente invention peut être inclus dans une source optique multi-longueurs d'ondes accordable. Une telle source peut comporter typiquement une section centrale à gain d'une longueur de l'ordre 400µm, encadrée respectivement de part et d'autre, dans la direction de propagation, par deux filtres multi-longueurs d'onde ayant chacun une longueur L de l'ordre de 500µm, ce qui conduit à un objet d'une longueur totale de l'ordre de 1,4mm.

L'inventeur a testé le filtre multi-longueurs d'onde conforme à la présente invention sur un laser à réflecteur de Bragg distribué, sous le seuil, comprenant un réseau continu contenant six fréquences espacées.

Pour cela, un matériau semi-conducteur comportant en surface une couche de résine photosensible a été insolé successivement avec six systèmes de franges de périodes différentes obtenues en sortie d'un montage d'interférences en lumière U.V.-laser Argon. La période du système de franges a été modifiée par changement de l'angle d'incidence des faisceaux sur l'échantillon.

Plus précisément, la durée de chaque insolation a été fixée à 1/6 de la durée totale nécessaire dans le but de rechercher des réseaux de même efficacité, c'est-à-dire une même réflectivité pour toutes les périodes.

La couche de résine photosensible insolée et développée a permis de graver le matériau semi-conducteur. La couche de résine photosensible sert ainsi de masque pour transférer les informations du masque de résine dans le matériau semiconducteur.

La caractérisation du transfert des six périodes après gravure a été faite par diffraction optique (avec la même raie U.V. que celle qui a été utilisée pour l'écriture).

Cette caractérisation a permis l'observation de six taches de diffraction, chacune correspondant à une période inscrite. L'intensité diffractée par chaque période a été mesurée. Cette mesure permet de corréler l'intensité à la forme du réseau correspondant, et donc dans une condition guidante donnée, au couplage qui en résulte.

Pour des durées d'insolation toutes égales, l'inventeur a mesuré des valeurs de diffraction variant au maximum de 6dB, ce qui correspond à un facteur 0.7 entre les couplages assurés par les réseaux.

L'inventeur a vérifié par ailleurs qu'à des durées d'insolation différentes correspondent des intensités diffractées différentes donc des réflectivités associées à une longueur d'onde différentes. On peut par conséquent obtenir ainsi un filtre ayant une réflectivité spécifique pour chaque longueur d'onde en contrôlant la durée relative d'insolation pour chaque fréquence.

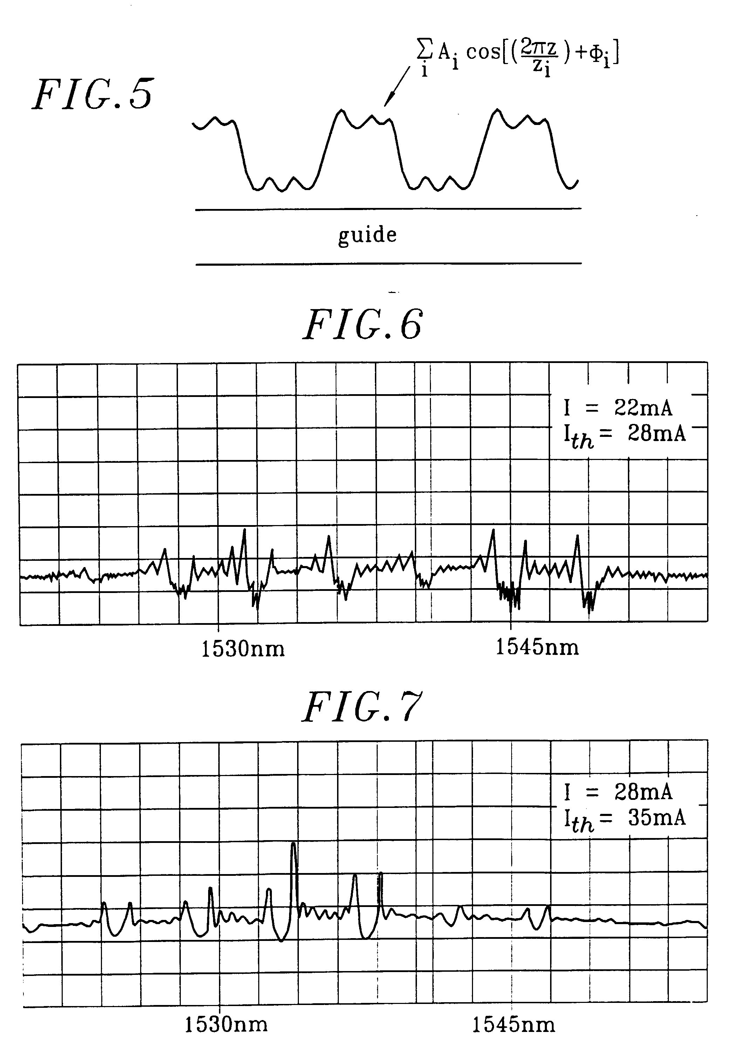

L'inventeur a alors testé le filtre actif ainsi obtenu formé par une structure laser à réseau continu du type illustré sur la figure 4.

Sur cette figure 4, on trouve entre deux couches de métallisation 30, 32 assurant la polarisation, un substrat InP 33, une couche de matériau actif 34, la couche de matériau quaternaire GalnAsP 35 dans laquelle ont été transférées les six périodes différentes précitées, et enfin une couche supérieure 36 d'InP. Les deux faces de matériau actif 34 ont été traitées anti-reflets.

Plus précisément, l'inventeur a testé deux structures conformes à la figure 4 sous un courant inférieur au seuil, plus précisément sous un courant égal à 0,8 fois le courant seuil.

Les figures 6 et 7 illustrent respectivement le spectre à bas courant obtenu sur ces deux structures actives.

La figure 6 correspond à une structure active possédant un courant seuil de 28mA et un courant de fonctionnement 22mA, tandis que la figure 7 correspond à une structure active possédant un courant seuil de 35mA et un courant de fonctionnement de 28mA.

Comme on le voit sur les figures 6 et 7 les spectres relevés permettent d'observer les six bandes associées respectivement aux 6 fréquences des réseaux 20ᵢ.

L'espacement entre le centre de ces bandes résulte de l'espacement entre les périodes des réseaux 20. La largeur d'une bande représente l'efficacité d'un réseau 20ᵢ.

On observe un espacement régulier entre les bandes et des bandes de largeurs comparables.

Chaque bande est l'équivalent dans un matériau actif de la largeur du spectre de réflectivité dans un matériau passif.

Bien entendu l'invention n'est pas limitée aux modes de réalisation particuliers qui viennent d'être décrits.

En particulier, le transfert de différents réseaux élémentaires 20ᵢ dans une seule et même couche du filtre ou encore dans plusieurs couches superposées du filtre, peut faire l'objet de nombreuses variantes.

Ainsi, selon une autre variante de mise en oeuvre, le réseau complet comportant toutes les périodes en toute section élémentaire du guide, constitué par la somme de différents réseaux dont les périodes correspondent respectivement aux diverses fréquences du filtre, peut être obtenu à l'aide d'un masqueur électronique définissant directement une forme géométrique, à l'échelle de chaque trait du réseau, qui représente la somme des périodes voulues avec la forme voulue pour chaque période. La contribution en amplitude de chaque réseau peut dans ce cas être contrôlée par la forme géométrique du réseau résultant de la dose appliquée par le masqueur.

On veut disposer des périodes Zi. Pour chaque période, la forme géométrique du réseau peut être représentée (au premier ordre de sa décomposition) par Ai cos(2πz/Zi). La réflectivité sur la lumière guidée à la fréquence Fi associée à la période Zi dépend de Ai. Le réseau obtenu comme somme de réseaux correspond à (toujours au premier ordre) :
ΣᵢAi cos((2πz/Zi) + Θi), Θi représentant la phase de chaque période par rapport à une référence.

Cette forme géométrique peut correspondre au schéma de la figure 5 sur laquelle on aperçoit un réseau superposé à une couche guidante. L'allure du réseau somme des réseaux dépend des phases relatives.

Le filtre conforme à la présente invention peut être accordable en disposant des moyens d'injection de courant dans celui-ci, en regard de la zone comportant les différents réseaux. Il suffit pour cela de placer une éléctrode sur la zone précitée. De façon connue en soi, l'accord du filtre résulte de la modification d'indice optique du milieu formant le filtre, suite à l'injection contrôlée de courant.

L'inventeur a testé également un filtre multilongueurs d'onde conforme à la présente invention dans une structure de laser DBR à trois sections comportant une section centrale active de 400µm de longueur encadrée par deux filtres à cinq périodes (comprenant chacun cinq réseaux superposés) : un premier filtre de 150µm de longueur dans lequel les périodes sont espacées de 0,89nm pour un espacement entre longueurs d'onde de 5,69nm, et un second filtre de 240µm de longueur dans lequel les périodes sont espacées de 0,72nm pbur un espacement entre longueurs d'onde de 4,6nm. Cette structure a été obtenue par trois étapes d'épitaxie. La section centrale à gain a été réalisée lors d'une première étape par technique LPE et couplée à un guide passif GalnAsP réalisé également par technique LPE, objet par ailleurs d'insolations multiples correspondant aux différentes longueurs d'onde recherchées. Un ruban est ensuite gravé chimiquement dans la structure et enterré par recroissance d'InP type p par MOVPE. Une implantation de proton assure une limitation de courant dans le ruban actif.

Selon une autre caractéristique avantageuse de l'invention, une zone de phase peut être adjointe au dispositif. De façon connue en soi une telle zone est composée d'une zone de propagation munie d'une électrode pour l'injonction d'un courant contrôlé. Cette injonction de courant permet de modifier l'indice optique de la zone concernée. Ainsi la phase du signal peut être modifiée par changement de chemin optique parcouru. Cette disposition permet d'accorder les modes de cavités avec les réflecteurs.

Une telle zone de phase peut être intercalée par exemple entre une zone active à gain et un filtre réflecteur multi-longueurs d'ondes conforme à la présente invention, dans une structure comportant un tel filtre unique, ou encore dans une structure comportant deux filtres respectivement à chaque extrémité de la zone active.

## Revendications

1. Filtre optique multi-longueurs d'ondes guidées, comprenant un guide d'onde (24, 22₁, ... 22ᵢ; 35) comportant un réseau continu constitué de plusieurs réseaux élémentaires (20₁, ... 20ᵢ) dont les périodes (Λ₁,...Λᵢ) correspondent respectivement aux diverses longueurs d'onde du filtre, les différents réseaux élémentaires (20) étant inscrits dans une même couche guidante (35) ou dans des couches guidantes superposées (22₁, ...22ᵢ) du guide d'onde (24), caractérisé par le fait que chaque réseau élémentaire (20ᵢ) s'étend sur toute la longueur du réseau continu de sorte que ce dernier comporte en chaque partie élémentaire (L) lesdits plusieurs réseaux élémentaires (20ᵢ) superposés.

2. Filtre selon la revendication 1, caractérisé par le fait que le nombre de réseaux élémentaires superposés est supérieur à 2.

3. Filtre optique selon l'une des revendications 1 ou 2, caractérisé par le fait que la contribution en amplitude de chaque réseau élémentaire est contrôlée, de façon à contrôler la réflectivité pour chaque longueur d'onde.

4. Filtre optique selon l'une des revendications 1 à 3, caractérisé par le fait que les phases relatives des différents réseaux élémentaires sont contrôlées.

5. Filtre optique selon l'une des revendications 1 à 3, caractérisé par le fait que les phases relatives des différents réseaux élémentaires sont aléatoires.

6. Filtre optique selon l'une des revendications 1 à 5, caractérisé par le fait que l'espacement en longueurs d'onde entre deux canaux du filtre est supérieur ou égal à 0,5nm.

7. Filtre optique selon l'une des revendications 1 à 6, caractérisé par le fait que la longueur (L) du filtre comprenant un réseau continu comportant en chaque partie élémentaire différents réseaux élémentaires superposés est de l'ordre de100µm.

8. Filtre selon l'une des revendications 1 à 7, caractérisé par le fait qu'il constitue un filtre passif.

9. Filtre selon l'une des revendications 1 à 7, caractérisé par le fait qu'il constitue un filtre actif.

10. Filtre selon l'une des revendications 1 à 9, caractérisé par le fait que le réseau continu (20₁, 20ᵢ) constitue un réseau de surface réflectif pour les ondes guidées dans une couche guidante adjacente (24) constituant le guide d'onde.

11. Filtre selon l'une des revendications 1 à 10, caractérisé par le fait qu'il constitue une source laser accordable comprenant une section centrale de gain encadrée de part et d'autre, dans la direction de propagation, par deux sections guidantes comprenant chacune un réseau continu formé en tout point par superposition de différents réseaux élémentaires (20).

12. Filtre selon l'une des revendications 1 à 11, caractérisé par le fait qu'il est accordable.

13. Filtre selon la revendication 12, caractérisé par le fait qu'il comprend des moyens d'injection de courant comportant une électrode sur la zone des réseaux superposés.

14. Filtre selon l'une des revendications 1 à 13, caractérisé par le fait qu'il comprend au moins une zone de phase, constituée d'une zone de propagation pourvue d'une électrode d'injection de courant, entre une section active et une section à réseaux multiples superposés.

15. Procédé de fabrication d'un filtre optique selon l'une des revendications 1 à 14, caractérisé par le fait qu'il comprend l'étape de réalisation du réseau continu par insolation d'une résine photosensible par différents systèmes de franges correspondant aux périodes respectives des réseaux élémentaires et transfert de ces systèmes de franges dans une couche semiconductrice.

16. Procédé selon la revendication 15, caractérisé par le fait que la contribution en amplitude de chaque réseau est contrôlée par la durée relative d'insolation par chaque systéme de frange.

## Patentansprüche

1. Optischer Filter für mehrere geführte Wellenlängen, mit einer Wellenführung (24, 22₁, ... 22ᵢ; 35), die mehrere Elementargitter (20₁, ... 20ᵢ) aufweist, deren Perioden (Λ1, ... Λi) jeweils den verschiedenen Wellenlängen des Filters entsprechen, wobei die verschiedenen Elementargitter (20) in dieselbe Führungsschicht (35) oder in aufeinander angeordneten Führungsschichten (22₁, ... 22ᵢ) der Wellenführung (24) eingeschrieben sind, dadurch gekennzeichnet, daß jedes Elementargitter (20ᵢ) sich über die gesamte Länge des kontinuierlichen Gitters derart erstreckt, daß letzteres in jedem Elementarabschnitt (L) diese mehreren übereinander angeordneten Elementargitter (20ᵢ) aufweist.

2. Filter nach Anspruch 1, dadurch gekennzeichnet, daß die Anzahl der übereinander angeordneten Elementargitter größer als 2 ist.

3. Optisches Filter nach Anspruch 1 oder 2, dadurch gekennzeichnet, daß der Amplitudenbeitrag jedes Elementargitters gesteuert wird, um die Reflektivität für jede Wellenlänge zu steuern.

4. Optisches Filter nach einem der Ansprüche 1 bis 3, dadurch gekennzeichnet, daß die relativen Phasen der verschiedenen Elementargitter gesteuert sind.

5. Optisches Filter nach einem der Ansprüche 1 bis 3, dadurch gekennzeichnet, daß die relativen Phasen der verschiedenen Elementargitter willkürlich sind.

6. Optisches Filter nach einem der Ansprüche 1 bis 5, dadurch gekennzeichnet, daß der Wellenlängenabstand zwischen zwei Filterkanälen größer oder gleich 0,5nm ist.

7. Optisches Filter nach einem der Ansprüche 1 bis 6, dadurch gekennzeichnet, daß die Länge L des Filters, das ein kontinuierliches Gitter mit verschiedenen aufeinander angeordneten Elementargittern in jedem Elementarbereich aufweist, in der Größenordnung von 100 µm liegt.

8. Filter nach einem der Ansprüche 1 bis 7, dadurch gekennzeichnet, daß es ein passives Filter bildet.

9. Filter nach einem der Ansprüche 1 bis 7, dadurch gekennzeichnet, daß es ein aktives Filter bildet.

10. Filter nach einem der Ansprüche 1 bis 9, dadurch gekennzeichnet, daß das kontinuierliche Gitter (20₁, 20ᵢ) ein für die geführten Wellen reflektierendes Oberflächengitter in einer die Wellenführung bildenden anliegenden Führungsschicht (24) bildet.

11. Filter nach einem der Ansprüche 1 bis 10, dadurch gekennzeichnet, daß es eine abstimmbare Laserquelle mit einem zentralen Verstärkungsabschnitt bildet, der an beiden Seiten in Ausbreitungsrichtung von zwei Führungsabschnitten umgeben ist, die jeweils ein an jedem Punkt durch Überlagerung verschiedener Elementargitter (20) gebildetes kontinuierliches Gitter aufweisen.

12. Filter nach einem der Ansprüche 1 bis 11, dadurch gekennzeichnet, daß es abstimmbar ist.

13. Filter nach Anspruch 12, dadurch gekennzeichnet, daß es Strominjektionsmittel mit einer Elektrode auf der Zone der übergeordneten Gitter aufweist.

14. Filter nach einem der Ansprüche 1 bis 13, dadurch gekennzeichnet, daß es wenigstens eine Phasenzone aufweist, die durch eine mit einer Strominjektionselektrode versehenen Ausbreitungszone gebildet ist, zwischen einem aktiven Abschnitt und einem Abschnitt mit mehreren aufeinander angeordneten Gittern.

15. Herstellungsverfahren für einen optischen Filter nach einem der Ansprüche 1 bis 14, dadurch gekennzeichnet, daß es den Schritt für die Herstellung des kontinuierlichen Gitters durch Bestrahlung eines lichtempfindlichen Harzes mit unterschiedlichen, den jeweiligen Perioden der Elementargitter entsprechenden Streifensystemen und das Übertragen dieser Streifensysteme in eine Halbleiterschicht umfaßt.

16. Verfahren nach Anspruch 15, dadurch gekennzeichnet, daß der Amplitudenbeitrag jedes Gitters durch die relative Bestrahlungsdauer jedes Streifensystems gesteuert wird.

## Claims

1. A multiwavelength guided wave optical filter comprising a waveguide (24, 22₁, ... 22ᵢ, 35) including a continuous grating constituted by a plurality of elementary gratings (20₁, ... 20ᵢ) whose periods (Λ₁, ... Λᵢ) correspond respectively to the various wavelengths of the filter, the various elementary gratings (20) being inscribed in a common waveguide layer (35) or in superposed waveguide layers (22₁, ... 22ᵢ) of the waveguide (24), the filter being characterized by the fact that each elementary grating (20ᵢ) extends over the entire length of the continuous grating so that the continuous grating includes, in each elementary portion (L), said plurality of superposed elementary gratings (20ᵢ).

2. A filter according to claim 1, characterized by the fact that the number of superposed elementary gratings is greater than 2.

3. An optical filter according to claim 1 or 2, characterized by the fact that the amplitude contribution of each elementary grating is controlled so as to control reflectivity for each wavelength.

4. An optical filter according to any one of claims 1 to 3, characterized by the fact that the relative phases of the various elementary gratings are controlled.

5. An optical filter according to any one of claims 1 to 3, characterized by the fact that the relative phases of the various elementary gratings are random.

6. An optical filter according to any one of claims 1 to 5, characterized by the fact that the wavelength spacing between two channels of the filter is greater than or equal to 0.5 nm.

7. An optical filter according to any one of claims 1 to 6, characterized by the fact that the length (L) of the filter comprising a continuous grating including different superposed elementary gratings in each elementary portion is of the order of 100 µm.

8. A filter according to any one of claims 1 to 7, characterized by the fact that it constitutes a passive filter.

9. A filter according to any one of claims 1 to 7, characterized by the fact that it constitutes an active filter.

10. A filter according to any one of claims 1 to 9, characterized by the fact that the continuous grating (20₁, 20ᵢ) constitutes a reflective surface grating for the waves guided in the adjacent waveguide layer (24) constituting the waveguide.

11. A filter according to any one of claims 1 to 10, characterized by the fact that it constitutes a tunable laser source comprising a central gain section between, in the propagation direction, two waveguide sections each comprising a continuous grating formed at all points by a superposition of various elementary gratings (20).

12. A filter according to any one of claims 1 to 11, characterized by the fact that it is tunable.

13. A filter according to claim 12, characterized by the fact that it includes current injection means comprising an electrode on the superposed grating zone.

14. A filter according to any one of claims 1 to 13, characterized by the fact that it includes at least one phase zone constituted by a propagation zone provided with a current injection electrode, located between an active section and a section having multiple superposed gratings.

15. A method of manufacturing an optical filter according to any one of claims 1 to 14, characterized by the fact that it comprises the step of making the continuous grating by exposing a photosensitive resin to various systems of fringes corresponding to the respective periods of the elementary gratings, and by transferring said systems of fringes into a semiconductor layer.

16. A method according to claim 15, characterized by the fact that the amplitude contribution of each grating is controlled by the relative duration of the exposure of each system of fringes.
